(19) Europäisches Patentamt / European Patent Office / Office européen des brevets

(11) **EP 4 501 500 A1**

(12) **EUROPEAN PATENT APPLICATION**
published in accordance with Art. 153(4) EPC

(43) Date of publication:
**05.02.2025 Bulletin 2025/06**

(21) Application number: **23779613.1**

(22) Date of filing: **15.03.2023**

(51) International Patent Classification (IPC):
**B23B 27/14** (2006.01)     **C23C 16/36** (2006.01)

(52) Cooperative Patent Classification (CPC):
**B23B 27/14; C23C 16/36**

(86) International application number:
**PCT/JP2023/010052**

(87) International publication number:
**WO 2023/189595 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.03.2022 JP 2022055518**

(71) Applicant: **Mitsubishi Materials Corporation Tokyo 100-8117 (JP)**

(72) Inventors:
- **TATSUOKA Sho**
  **Naka-shi, Ibaraki 311-0102 (JP)**
- **TOJO Shunsuke**
  **Naka-shi, Ibaraki 311-0102 (JP)**

(74) Representative: **Gille Hrabal Partnerschaftsgesellschaft mbB Patentanwälte Brucknerstraße 20 40593 Düsseldorf (DE)**

(54) **SURFACE-COATED CUTTING TOOL**

(57) A surface coated cutting tool includes a substrate and a coating layer. The coating layer includes a complex carbonitride layer. The complex carbonitride layer has an average thickness of 1.0 um or more and 20.0 um or less. The complex carbonitride layer includes NaCl-type face-centered cubic crystal grains, each containing: metal components Ti, V, Zr, and Nb in atomic fractions $a_1$, $a_2$, $a_3$, and $a_4$, respectively, where the total atomic fraction of the metal components in the layer is 1; non-metallic components C and N in atomic fractions $b_1$ and $b_2$, respectively, where the total atomic fraction of the non-metallic components is 1; and inevitable impurities. The atomic fractions $a_1$, $a_2$, $a_3$, $a_4$, $b_1$, and $b_2$ satisfy the relations:

$$0.01 \leq a_1 \leq 0.60,$$

$$0.01 \leq a_2 \leq 0.60,$$

$$0.01 \leq a_3 \leq 0.60,$$

$$0.01 \leq a_4 \leq 0.60,$$

$$0.20 \leq b_1 \leq 0.80,$$

and

$$0.20 \leq b_2 \leq 0.80.$$

[Fig. 2]

## Description

### Technical Field

The present invention relates to surface coated cutting tools (hereinafter referred to as "coated tools"). This application claims priority based on Japanese Patent Application No. 2022-55518 filed on March 30, 2022. The entire description in the Japanese patent application is hereby incorporated by reference.

### Background Art

A coated tool is known including a substrate composed of tungsten carbide (hereinafter denoted by WC) based cemented carbide, for example, and a coating layer on the substrate. Such coated tools exhibit high wear resistance. Various proposals have also been made on improvements in coating layers in order to enhance the durability of coated tools.

For example, PTL 1 discloses a tool including a substrate and a coating layer on the substrate, in which the coating layer has a composition represented by $(Ti_xZr_{1-x})(C_yN_{1-y})$ (where $0.4 < x < 0.95$, $0.2 < y < 0.9$) having a face-centered cubic structure with a lattice constant of 0.403 to 0.455 nm or by $(Ti_xHf_{1-x})(C_yN_{1-y})$ (where $0.4 < x < 0.95$, $0.2 < y < 0.9$) having a face-centered cubic structure with a lattice constant of 0.430 to 0.450 nm. Such a coating layer is hard and has high wear resistance.

PTL 2 describes a coated tool (insert) including a substrate and a coating layer on the substrate, in which the coating layer is composed of fcc $Ti_{1-x}Me_x$ nitride ($0.1 \leq x \leq 0.9$, Me being one or more of Zr and Hf) having a lattice constant of 0.427 to 0.453 nm. The coating layer of the coated tool is hard and suitable for dry cutting of stainless steel.

### Citation List

### Patent Literature

PTL 1: Japanese Patent No. 4028891
PTL2: US Patent Application Publication No. 2016/0298233

### Summary of Invention

### Technical Problem

An object of the present invention, which has been accomplished in view of the aforementioned circumstances and proposal, is to provide a coated tool having a coating layer with high hardness and improved toughness.

### Solution to Problem

The surface coated cutting tool according to the embodiment of the present invention comprises:

a substrate and a coating layer on a surface of the substrate,
the coating layer comprising a complex carbonitride layer,
the complex carbonitride layer having an average thickness of 1.0 um or more and 20.0 um or less,
the complex carbonitride layer comprising NaCl-type face-centered cubic crystal grains each containing:

metal components Ti, V, Zr, and Nb in atomic fractions $a_1$, $a_2$, $a_3$, and $a_4$, respectively, where the total atomic fraction of the metal components in the layer is 1;
non-metallic components C and N in atomic fractions $b_1$ and $b_2$, respectively, where the total atomic fraction of the non-metallic components is 1; and
inevitable impurities, wherein

the atomic fractions $a_1$, $a_2$, $a_3$, $a_4$, $b_1$, and $b_2$ satisfy the following relations:

$$0.01 \leq a_1 \leq 0.60,$$

$$0.01 \leq a_2 \leq 0.60,$$

$$0.01 \leq a_3 \leq 0.60,$$

$$0.01 \leq a_4 \leq 0.60,$$

$$0.20 \leq b_1 \leq 0.80,$$

and $0.20 \leq b_2 \leq 0.80$,

the crystal grains each have a configuration parameter $S_{config}$ expressed by Expression 1 of 0.80R or more,

$$S_{config} = -\frac{R}{2}\left[\sum_{i=1}^{n} a_i ln(a_i) + \sum_{j=1}^{m} b_j ln(b_j)\right] \tag{1}$$

where n = 4 and m = 2, ln represents the natural logarithm, and R represents the gas constant.

The surface coated cutting tool of the above embodiment may satisfy at least one of the following items (1) and (2):

(1) The complex carbonitride layer further contains at least one metallic component selected from the group consisting of Hf and Ta in atomic fractions of $a_5$ and $a_6$, respectively, wherein

the atomic fractions $a_5$ and $a_6$ satisfy the following relations:

$$a_5 < 0.01,$$

and

$$a_6 < 0.01,$$

respectively,

the crystal grains each have a configuration parameter $S_{config}$ expressed by Expression 1 of 0.80R or more,

where n = 6 and m = 2, ln represents the natural logarithm, and R represents the gas constant, with the proviso that if $a_i$ (i = 5 or 6) is zero (not contained), $a_i ln(a_i) = 0$.

(2) The complex carbonitride layer further contains 0.50 atomic percent or less of Cl.

**Advantageous Effects of Invention**

The embodiment of the surface-coated cutting tool includes a coating layer having high hardness and high toughness.

**Brief Description of Drawings**

Fig. 1 is a schematic diagram of the crystal structure of TiN.
Fig. 2 is a schematic diagram of the crystal structure of (TiVZrNb)(CN) or (TiVZrNbHfTa)(CN) .

**Description of Embodiments**

Since the hardness and toughness of the coating layer of a surface-coated cutting tool are in a trade-off relationship, it is believed to be difficult to achieve both by the conventional solid solution strengthening theory.
Meanwhile, research has recently been conducted on solid solutions with increased entropy of mixing, such as high-entropy alloys, which consist of five or more elements mixed in substantially equal atomic proportions, and multi principal element alloys, which consist of three or more elements containing at least two or more principal elements. No research, however, are found on increasing the entropy of mixing in the coating layer of coated tools.

The inventor has made an extensive study on the solid solution (alloy) that constitutes the coating layer of the coated tool to achieve compatibility between high hardness and high toughness through increasing the entropy of mixing, which have been in trade-off relation and have not been achieved in conventional coating layers.

As a result, the inventor found that an increase in entropy in the complex carbonitride layer of a specific composition which constitutes the coating layer of the coated tool leads to:

(i) formation of a complex carbonitride layer with a specific composition composed of several atoms with different atomic radii causing distortion in crystal grains and thus improving hardness and toughness; and
(ii) improvements in thermal stability and oxidation resistance of the complex carbonitride layer at high temperatures.

The surface-coated cutting tools of the present invention will now be described.

Throughout the specification and the claims, a numerical range expressed as "L to M" (L and M are both numerical values) is synonymous with "L or more and M or less," and the range includes the upper limit (M) and the lower limit (L). In the case that units are stated only for the upper limit, the units for the upper (M) and lower (L) limits are the same.

I. First Embodiment

The complex carbonitride of (TiVZrNb) (may also be denoted as (TiVZrNb) (CN)), which constitutes the coating layer of the first embodiment, will now be described.

1. Coating layer

1-1. (TiVZrNb)(CN) layer

(1) Crystal structure

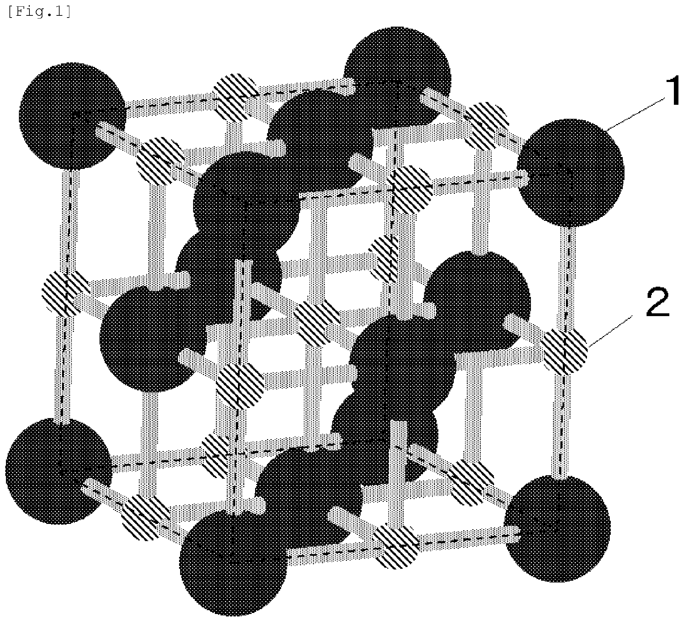

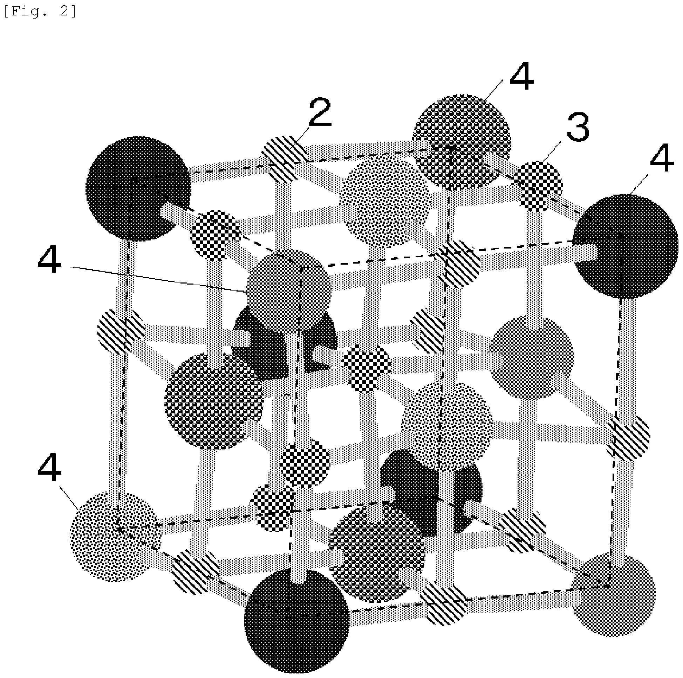

(TiVZrNb)(CN) has an atomic arrangement shown in Fig. 2. Ti, V, Zr, or Nb atoms, which have different atomic radii, are present in the cationic site (4), and C and N atoms are mixed at random or without regularity in the anionic sites (2 and 3), in a crystal lattice. Compared to the crystal structure of TiN (Ti atoms (1) and N atoms (2)) shown schematically in Fig. 1, each atom is displaced from the ideal lattice point in this crystal lattice. This causes strain in the crystal lattice (indicated by the displacement from the dotted line in Fig. 2), and this strain results in improved hardness and toughness. The extent of displacement of each atom is also shown schematically in Fig. 2.

(2) Average thickness

The average thickness of the (TiVZrNb)(CN) layer, which is a complex carbonitride layer, should preferably be 1.0 pm or more and 20.0 $\mu$m or less, for the following reasons: An average thickness of less than 1.0 um, which is significantly small, leads to insufficient durability of the (TiVZrNb) (CN) layer. An average thickness exceeding 20.0 um leads to ready formation of coarse crystal grains in the (TiVZrNb) (CN) layer, resulting in frequent chipping. The average thickness of the (TiVZrNb) (CN) layer should more preferably be 3.0 um or more and 16.0 um or less.

(3) Composition

The (TiVZrNb)(CN) layer, which is a complex carbonitride layer, preferably has a composition represented by the chemical formula: $(Ti_{a1}V_{a2}Zr_{a3}Nb_{a4})(C_{b1}N_{b2})$, where the atomic fractions $a_1$, $a_2$, $a_3$, $a_4$, $b_1$, $b_2$ satisfy the following relations:

$$a_1 + a_2 + a_3 + a_4 = 1 \text{ and } b_1 + b_2 = 1;$$

$$0.01 \leq a_1 \leq 0.60;$$

$$0.01 \leq a_2 \leq 0.60;$$

$$0.01 \leq a_3 \leq 0.60;$$

$$0.01 \leq a_4 \leq 0.60;$$

$$0.20 \leq b_1 \leq 0.80;$$

$$0.20 \leq b_2 \leq 0.80;$$

and the crystal grains in the layer each have a configuration parameter $S_{config}$ expressed in Expression 1 is 0.80R or more where n = 4 and m = 2, ln represents the natural logarithm, and R represents the gas constant.

The layer may contain unintended or inevitable impurities that are introduced during the manufacturing process.

$$S_{config} = -\frac{R}{2}\left[\sum_{i=1}^{n} a_i ln(a_i) + \sum_{j=1}^{m} b_j ln(b_j)\right] \tag{1}$$

The atomic fractions $a_1$, $a_2$, $a_3$, $a_4$, $b_1$ and $b_2$ satisfying the relations causes the entropy of mixing of the (TiVZrNb) (CN) layer to be enhanced, and the (TiVZrNb) (CN) layer to have the advantageous effects (i)-(ii) found by the inventor.

The atomic fractions $a_1$, $a_2$, $a_3$, $a_4$, $b_1$, and $b_2$ should preferably be determined such that the configuration parameter $S_{config}$ has a larger value. The upper limit for the calculation of the configuration parameter $S_{config}$ is 1.04R.

(4) Cl content

Cl is inevitablely contained in a very trace amount (an amount the presence of which can only just be confirmed by analysis by single-element detection of chlorine only) in the layer deposited by the CVD process using a chloride raw material gas. A Cl content of 0.50 atomic percent or less causes a lubricant (TiVZrNb)(CN) layer to be formed due to the effect of Cl. The Cl content (atomic percent) is defined by the percentage to all atoms of Ti, V, Zr, Nb, C, N, and Cl.

(5) NaCl-type face-centered cubic structure

The (TiVZrNb)(CN) layer should preferably contain crystal grains with a NaCl-type face-centered cubic structure. The layer may also contain crystal grains other than the NaCl-type face-centered cubic structure, but the presence of crystal grains other than the NaCl-type face-centered cubic structure is not intended. Having crystal grains with a NaCl-type face-centered cubic structure in the claims and specification means that crystal grains other than this unintended NaCl-type face-centered cubic structure may be present in addition to crystal grains with a NaCl-type face-centered cubic structure.

1-2. Other layers

(1) bottom layer

A bottom layer may be disposed between the substrate and the (TiVZrNb) (CN) layer, where the bottom layer consists of one or more sublayers each composed of titanium nitride, titanium carbide, or titanium carbonitride (not limited to stoichiometric composition) with a total average thickness of 0.1 to 20.0 um. The bottom layer improves the adhesion between the substrate and the (TiVZrNb)(CN) layer.

(2) Top layer

A top layer may be disposed on the (TiVZrNb) (CN) layer, where the top layer consists of one or more sublayers each composed of titanium nitride, titanium carbide, titanium carbonitride, titanium oxide and/or aluminum oxide (not limited to stoichiometric composition) with a total average thickness of 0.1 to 25.0 $\mu$m. The top layer improves chipping and wear resistance.

(3) Unintentionally generated layers

If the pressure and/or temperature of the gas in the CVD furnace is unstable, a layer different from the (TiVZrNb)(CN) layer, bottom layer, and top layer may be deposited unintentionally.

2. Substrate

(1) Material

The substrate may be of any known substrate material that does not hinder the achievement of the purpose of the invention. Examples of such a material include WC-based cemented carbides (containing carbides or nitrides of Co, Ti, Zr, Ta, Nb, and Cr, in addition to WC), cermets (mainly composed of TiC, TiN, and TiCN), ceramics (titanium carbide, silicon carbide, silicon nitride, aluminum nitride, and aluminum oxide), and cBN compacts.

(2) Shape

The substrate may have any shape suitable for use in a cutting tool, for example, shapes of an insert and a solid tool.

3. Measurement

The average thickness, the contents of individual elements, and the average chlorine content of the (TiVZrNb)(CN) layer are determined as follows:

(1) Average thickness

The average thickness of the (TiVZrNb)(CN) layer can be determined as follows: A sample for observation of the longitudinal section of the coating layer is prepared with a cross-section polisher (CP) or any other instrument, the longitudinal section is observed with a scanning electron microscope (SEM), and then the thickness of the layer is measured at several sites (e.g., at five sites). The thicknesses at several sites are averaged into the average thickness of the (TiVZrNb)(CN) layer. The definition of the surface of the substrate will be described below.
The longitudinal section indicates a cross-section perpendicular to a surface (regarded as a flat surface without irregularities) of the substrate in the case of the insert.
The surface of the substrate is defined by the average line (straight line) of the rough interface between the substrate and the coating layer in the observed image of the longitudinal section.
The interface between the (TiVZrNb)(CN) coating layer (or the bottom layer if present) and the substrate is determined from the observed image of the longitudinal section described above. The average line of the roughness curve of the interface is defined as the surface of the substrate. The direction perpendicular to the average line is the direction perpendicular to the substrate (thickness direction of the layer).
In the case that the radius of curvature of the curved surface is sufficiently large relative to the thickness of the coating layer in the substrate having a curved surface, the interface between the coating layer and the substrate in the observation area is regarded as a plane surface; hence, the surface of the substrate can be determined by the same procedure.

(2) Contents of individual elements and chlorine in the coating layer

The contents of individual elements and chlorine in the (TiVZrNb)(CN) layer are determined as follows:
The Ti content $a_1$, V content $a_2$, Zr content $a_3$, Nb content $a_4$, the C content $b_1$, the N content $b_2$, and chlorine content are the averages of the results of characteristic X-ray analysis observed at ten points by irradiation of the polished surface of the sample of the coating layer with electron beams using an electron probe micro analyzer (EPMA).

(3) Identification of the crystal structure in the (TiVZrNb)(CN) layer

The (TiVZrNb) (CN) layer is subjected to X-ray diffractometry to confirm that the layer has a NaCl-type face-centered cubic structure. The X-ray diffraction is measured by the $2\theta$-$\theta$ method using CuK$\alpha$ rays, under the following conditions: scanning range ($2\theta$) of 15 to 135 degrees, X-ray output of 45 kV and 40 mA, divergence slit of 0.5 degrees, and scan step of 0.013 degrees.

4. Production

The (TiVZrNb)(CN) layer can be produced by a CVD process using, for example, $TiCl_4$, $ZrCl_4$, $VCl_4$, $NbCl_5$, $H_2$, HCl, $N_2$, $CH_3CN$, Ar, and $H_2$ gases.

II. Second embodiment

The complex carbonitride of (TiVZrNbHfTa) (sometimes denoted as (TiVZrNbHfTa) (CN)), which constitutes the coating layer of the second embodiment, will now be described.

1. Coating layer

1-1. (TiVZrNbHfTa)(CN) layer

(1) Crystal structure

The crystal structure is the one in which "(TiVZrNbHfTa) (CN)" and "Ti, V, Zr, Nb, Hf, Ta atoms (Hf and Ta are selected depending on the composition)" are substituted for " (TiVZrNb) (CN)" and "Ti, V, Zr, Nb atoms" respectively in the description of the first embodiment for the crystal structure.

(2) Average thickness

The average thickness is the replacement of "(TiVZrNb)" with "(TiVZrNbHfTa)" in the description of the first embodiment regarding average thickness.

(3) Composition

The (TiVZrNbHfTa)(CN) layer, which is a complex carbonitride layer, preferably has a composition represented by the chemical formula: $(Ti_{a1}V_{a2}Zr_{a3}Nb_{a4}Hf_{a5}Ta_{a6})(C_{b1}N_{b2})$, where the atomic fractions $a_1$, $a_2$, $a_3$, $a_4$, $a_5$, $a_6$, $b_1$, $b_2$ satisfy the following relations:

$$a_1 + a_2 + a_3 + a_4 + a_5 + a_6 = 1 \text{ and } b_1 + b_2 = 1;$$

$$0.01 \leq a_1 \leq 0.60;$$

$$0.01 \leq a_2 \leq 0.60;$$

$$0.01 \leq a_3 \leq 0.60;$$

$$0.01 \leq a_4 \leq 0.60;$$

$$0.00 \leq a_5 < 0.01;$$

$$0.00 \leq a_6 < 0.01;$$

$$0.20 \leq b_1 \leq 0.80;$$

$$0.20 \leq b_2 \leq 0.80;$$

and the crystal grains in the layer each have a configuration parameter $S_{config}$ expressed in Expression 1 is 0.80R or more where n = 6 and m = 2, In represents the natural logarithm, and R represents the gas constant.

The layer may contain unintended or inevitable impurities that are introduced during the manufacturing process.

$$S_{config} = -\frac{R}{2}\left[\sum_{i=1}^{n} a_i ln(a_i) + \sum_{j=1}^{m} b_j ln(b_j)\right]$$

(1)

At $a_i$ (i = 5 or 6) of 0.00 (in the case that Hf or Ta is not contained), $a_i ln(a_i)$ is regarded as 0 (zero).

The atomic fractions $a_1$, $a_2$, $a_3$, $a_4$, $a_5$, $a_6$, $b_1$ and $b_2$ satisfying the relations causes the entropy of mixing of the (TiVZrNbHfTa)(CN) layer to be enhanced, and the (TiVZrNbHfTa)(CN) layer to have the advantageous effects (i)-(ii) found by the inventor.

The atomic fractions $a_1$, $a_2$, $a_3$, $a_4$, $a_5$, $a_6$, $b_1$ and $b_2$ should preferably be determined such that the configuration parameter $S_{config}$ has a larger value. Since the upper limits of atomic fractions $a_5$ and $a_6$ are both less than 0.01, the upper limit for the calculation of the configuration parameter $S_{config}$ is 1.08R.

(4) Cl content

The Cl content is the replacement of "(TiVZrNb) (CN)" with "(TiVZrNbHfTa) (CN)" in the description of the first embodiment for the Cl content. The Cl content (atomic percent) is defined by the percentage of all atoms of Ti, V, Zr, Nb, Hf, Ta, C, N, and Cl.

(5) NaCl-type face-centered cubic structure

Regarding the NaCl-type face-centered cubic structure, "(TiVZrNb)" is replaced with "(TiVZrNbHfTa)" in the description of the first embodiment for NaCl-type face-centered cubic structure above.

1-2. Other layers

Regarding the other layers, "(TiVZrNb)" is replaced with "(TiVZrNbHfTa)" in the description of the first embodiment for the other layers.

2. Substrate

The substrate is the same as described in the first embodiment.

3. Measurement

Regarding the measurement, "(TiVZrNb)" is replaced with "(TiVZrNbHfTa)" in the description on the measurement of the first embodiment. The contents of Hf and Ta are also measured by EPMA.

4. Production

The (TiVZrNbHfTa)(CN) layer of this embodiment can be produced by CVD with, for example, deposition gases containing $HfCl_4$ and $TaCl_5$ in addition to $TiCl_4$, $ZrCl_4$, $VCl_4$, $NbCl_5$, $HfCl_4$, $TaCl_5$, $H_2$, HCl, $N_2$, $CH_3CN$, Ar and $H_2$ used in the first embodiment.

The above description supports the following Appendices:

(Appendix 1) A surface coated cutting tool comprising:

a substrate and a coating layer on a surface of the substrate,
the coating layer comprising a complex carbonitride layer,
the complex carbonitride layer having an average thickness of 1.0 um or more and 20.0 um or less,
the complex carbonitride layer comprising NaCl-type face-centered cubic crystal grains each containing:

metal components Ti, V, Zr, and Nb in atomic fractions $a_1$, $a_2$, $a_3$, and $a_4$, respectively, where the total atomic fraction of the metal components in the layer is 1;
non-metallic components C and N in atomic fractions $b_1$ and $b_2$, respectively, where the total atomic fraction of the non-metallic components is 1; and inevitable impurities, wherein

the atomic fractions $a_1$, $a_2$, $a_3$, $a_4$, $b_1$, and $b_2$ satisfy the following relations:

$$0.01 \le a_1 \le 0.60,$$

$$0.01 \le a_2 \le 0.60,$$

$$0.01 \le a_3 \le 0.60,$$

$$0.01 \le a_4 \le 0.60,$$

$$0.20 \le b_1 \le 0.80,$$

and

$$0.20 \le b_2 \le 0.80,$$

the crystal grains each have a configuration parameter $S_{config}$ expressed by Expression 1 of 0.80R or more,

$$S_{config} = -\frac{R}{2}\left[\sum_{i=1}^{n} a_i ln(a_i) + \sum_{j=1}^{m} b_j ln(b_j)\right] \qquad (1)$$

where n = 4 and m = 2, ln represents the natural logarithm, and R represents the gas constant.

(Appendix 2) The surface coated cutting tool set forth in Appendix 1, wherein the complex carbonitride layer further contains at least one metallic component selected from the group consisting of Hf and Ta in atomic fractions of $a_5$ and $a_6$, respectively, wherein

the atomic fractions $a_5$ and $a_6$ satisfy the following relations:

$$a_5 < 0.01,$$

and

$$a_6 < 0.01,$$

respectively,
the crystal grains each have a configuration parameter $S_{config}$ expressed by Expression 1 of 0.80R or more,

where n = 6 and m = 2, ln represents the natural logarithm, and R represents the gas constant, with the proviso that if $a_i$ (i = 5 or 6) is zero (not contained), $a_i ln(a_i) = 0$.
(Appendix 3) The surface coated cutting tool set forth in Appendix 1 or 2, wherein the complex carbonitride layer further contains 0.50 atomic percent or less of Cl.
(Appendix 4) The surface coated cutting tool set forth in any of Appendices 1 to 3, further comprising a bottom layer between the substrate and the complex carbonitride layer, the bottom layer including at least one sublayer composed of titanium nitride, titanium carbide, or titanium carbonitride and having a total average thickness of 0.1 to 20.0 um.
(Appendix 5) The surface coated cutting tool set forth in any of Appendices 1 to 4, further comprising a top layer on the complex carbonitride layer, the top layer including at least one sublayer composed of titanium nitride, titanium carbide, titanium carbonitride, or titanium oxide layer and having a total average thickness of 0.1 to 25.0 um.

Examples

The present invention will now be described by way of Examples. The present invention should not be limited to Examples. Examples show insert cutting tools including substrates made of WC-based cemented carbide, but the substrate may be composed of any of the aforementioned materials, and the cutting tool may have any other shape, such as a solid tool, as described above.

<Examples of first embodiment>

1. Production of substrate

WC, TiC, ZrC, TaC, NbC, $Cr_3C_2$, TiN, and Co raw powders were blended into compositions shown in Table 1, and then were ball-milled together with wax in acetone for 24 hours. After being dried under reduced pressure, each mixture was pressed into a green compact of a predetermined shape under a pressure of 98 MPa.
The green compact was then sintered under vacuum, and then the cutting edges of the sinter were honed to R of 0.05 mm. WC-based cemented carbide substrates A through C, each with an insert shape of CNMG120408-MA manufactured by Mitsubishi Materials Corporation were thereby produced.

2. Deposition

(TiVZrNb)(CN) layers were deposited on the surfaces of substrates A to C in a CVD system to yield Examples 1 to 10 shown in Table 5. The conditions for deposition were as shown in Table 2, and were generally as follows:
Composition of reaction gas (content of gas component is in volume %):

$TiCl_4$: 0.02 to 0.10%
ZrCl: 0.10 to 0.50%.
$VCl_4$: 0.02 to 0.10%
$NbCl_5$: 0.02 to 0.10%
$CH_3CN$: 0.10 to 0.50%,
HCl: 0.10 to 0.50%,
$N_2$: 0.0 to 12.0%,
Ar: 10.0 to 50.0%, and
$H_2$: balance
Pressure of reaction atmosphere: 4.5 to 12.0 kPa
Temperature of reaction atmosphere: 800 to 950°C

In Examples 3 to 10, the bottom layer (s) and/or top layer(s) shown in Table 4 were deposited under the conditions shown in Table 3.
For comparison, (TiVZrNb)(CN) layers were deposited on the surfaces of substrates A to C according to the conditions of deposition shown in Table 2 to yield Comparative Examples 1 to 10 shown in Table 5. For the production of the comparative examples, the composition of the raw material gases was varied from those of Examples. For comparative examples 3 to 10, the bottom layer (s) and/or the top layer(s) shown in Table 4 were deposited according to the conditions shown in Table 3.
To contrast the present invention with the conventional technology, a TiCN layer was deposited on the surface of substrate A and C under the conditions shown in Table 3 and a bottom sublayer shown in Table 4 was deposited to produce Conventional Example 1 shown in Table 5, or a bottom sublayer and top sublayers shown in Table 4 were deposited to produce Conventional Example 2 also shown in Table 5.
The average thickness of each layer, and the content of each element and the chlorine content in each layer were measured, and the NaCl-type face-centered cubic structure in each layer was identified for Examples 1 to 10, Comparative Examples 1 to 10, and Conventional Examples 1 to 2, by the methods described above.
The results are summarized in Table 5.

[Table 1]

| | Type | Composition (mass%) | | | | | | | |
|---|---|---|---|---|---|---|---|---|---|
| | | Co | TiC | ZrC | TaC | NbC | $Cr_3C_2$ | TiN | WC |
| Substrate | A | 6.1 | 0.0 | 1.5 | 0.5 | 2.8 | 0.1 | 1.5 | Balance |
| | B | 7.2 | 2.5 | 0.0 | 3.2 | 0.4 | 0.0 | 1.1 | Balance |
| | C | 5.5 | 0.0 | 0.0 | 0.0 | 0.0 | 0.0 | 0.0 | Balance |

[Table 2]

| Type of deposition process | Symbol | Formation of (TiVZrNb)(CN) layer | | | | | | | | | | |
|---|---|---|---|---|---|---|---|---|---|---|---|---|
| | | Composition of reaction gas (volume %) | | | | | | | | | Reaction atmosphere | |
| | | $TiCl_4$ | $VCl_4$ | $ZrCl_4$ | $NbCl_5$ | $CH_3CN$ | HCl | $N_2$ | Ar | $H_2$ | Pressure (kPa) | Temp. (° C) |
| Process of Examples | A | 0.10 | 0.10 | 0.10 | 0.10 | 0.30 | 0.30 | 0.0 | 35.0 | Balance | 4.5 | 900 |
| | B | 0.05 | 0.05 | 0.30 | 0.05 | 0.30 | 0.50 | 5.0 | 50.0 | Balance | 12.0 | 800 |
| | C | 0.02 | 0.05 | 0.30 | 0.02 | 0.50 | 0.30 | 0.0 | 10.0 | Balance | 7.0 | 950 |
| | D | 0.05 | 0.07 | 0.50 | 0.07 | 0.10 | 0.10 | 12.0 | 35.0 | Balance | 7.0 | 900 |
| | E | 0.07 | 0.10 | 0.50 | 0.05 | 0.10 | 0.30 | 0.0 | 25.0 | Balance | 4.5 | 950 |
| | F | 0.05 | 0.07 | 0.30 | 0.05 | 0.30 | 0.50 | 0.0 | 25.0 | Balance | 4.5 | 900 |
| | G | 0.10 | 0.07 | 0.20 | 0.05 | 0.30 | 0.30 | 2.0 | 25.0 | Balance | 7.0 | 900 |
| | H | 0.07 | 0.02 | 0.30 | 0.07 | 0.30 | 0.50 | 5.0 | 35.0 | Balance | 12.0 | 950 |
| | I | 0.07 | 0.05 | 0.10 | 0.10 | 0.30 | 0.10 | 12.0 | 50.0 | Balance | 4.5 | 800 |
| | J | 0.05 | 0.05 | 0.20 | 0.07 | 0.30 | 0.50 | 2.0 | 10.0 | Balance | 7.0 | 950 |
| Process of Comparative Examples | A' | 0.07 | 0.01 | 0.70 | 0.20 | 0.30 | 0.50 | 12.0 | 50.0 | Balance | 4.5 | 950 |
| | B' | 0.01 | 0.07 | 0.05 | 0.25 | 0.30 | 0.10 | 2.0 | 35.0 | Balance | 7.0 | 900 |
| | C' | 0.03 | 0.01 | 0.60 | 0.01 | 0.30 | 0.50 | 2.0 | 35.0 | Balance | 4.5 | 800 |
| | D' | 0.01 | 0.01 | 0.03 | 0.07 | 0.30 | 0.30 | 0.0 | 35.0 | Balance | 12.0 | 950 |
| | E' | 0.28 | 0.02 | 0.10 | 0.25 | 0.30 | 0.30 | 0.0 | 10.0 | Balance | 7.0 | 950 |
| | F' | 0.01 | 0.20 | 0.80 | 0.01 | 0.30 | 0.50 | 12.0 | 25.0 | Balance | 12.0 | 950 |
| | G' | 0.30 | 0.02 | 0.50 | 0.02 | 0.50 | 0.10 | 5.0 | 25.0 | Balance | 7.0 | 800 |
| | H' | 0.10 | 0.30 | 0.05 | 0.01 | 0.30 | 0.30 | 0.0 | 50.0 | Balance | 4.5 | 900 |
| | I' | 0.05 | 0.25 | 0.10 | 0.02 | 0.10 | 0.30 | 0.0 | 25.0 | Balance | 7.0 | 900 |
| | J' | 0.02 | 0.02 | 0.10 | 0.15 | 0.10 | 0.50 | 5.0 | 10.0 | Balance | 4.5 | 900 |

[Table 3]

| Sublayer Constituting coating layer | | Conditions of deposition (Pressure and temperature of reaction atmosphere are shown in kPa and ° C. respectively.) | | |
|---|---|---|---|---|
| Type | | Composition of reaction gas (volume %) | Reaction atmosphere | |
| | | | Pressure | Temperature |
| Ti com-pound layer | TiN | $TiCl_4$: 4.2%. $N_2$: 30%. $H_2$: Balance | 7.0 | 900 |
| | TiCN | $TiCl_4$: 2%, $CH_3CN$: 0.7%. $N_2$: 10%. $H_2$: Balance | 7.0 | 900 |
| | TiCNO | $TiCl_4$: 2%, $CH_3CN$: 0.7%, C0: 1%, $N_2$: 10%. $H_2$: Balance | 7.0 | 1000 |
| $Al_2O_3$ layer | $Al_2O_3$ | $AlCl_3$: 2.2%. $CO_2$: 5.5%. HCl: 2.2%, $H_2S$: 0.2%, $H_2$: Balance | 7.0 | 1000 |

[Table 4]

| Type | | Substrate symbol | Coating layer (Lower number indicates average thickness (μm) of layer.) | | | |
|---|---|---|---|---|---|---|
| | | | Bottom layer(s) | | Top layer(s) | |
| | | | First sublayer | Second sublayer | First sublayer | Second sublayer |
| Examples & Comparative Examples | 3 | C | TiN (0.3) | – | – | – |
| | 4 | A | TiN (0.1) | – | TiCNO (0.8) | $Al_2O_3$ (3.2) |
| | 5 | B | TiN (0.3) | TiCN (2.2) | TiCNO (0.3) | $Al_2O_3$ (8.1) |
| | 6 | C | TiN (1.5) | TiCN (3.7) | – | – |
| | 7 | A | – | – | $Al_2O_3$ (6.3) | – |
| | 8 | B | TiN (1.0) | TiCN (3.2) | TiCNO (0.2) | $Al_2O_3$ (4.2) |
| | 9 | C | TiN (0.4) | TiCN (2.0) | $Al_2O_3$ (3.4) | – |
| | 10 | A | TiN (0.3) | TiCN (3.8) | TiCNO (0.2) | $Al_2O_3$ (5.7) |
| Conventional Examples | 1 | C | TiN (0.2) | – | – | – |
| | 2 | A | TiN (0.2) | – | TiCNO (0.6) | $Al_2O_3$ (3.5) |

[Table 5]

| Type | | Substrate | Symbol of deposition | Content | | | | | | S_config/R | Cl content (atomic %) | Average thickness (μm) |
|---|---|---|---|---|---|---|---|---|---|---|---|---|
| | | | | $a_1$ | $a_2$ | $a_3$ | $a_4$ | $b_1$ | $b_2$ | | | |
| Examples | 1 | A | A | 0.29 | 0.05 | 0.31 | 0.35 | 0.59 | 0.41 | 0.96 | 0.02 | 5.5 |
| | 2 | B | B | 0.19 | 0.25 | 0.14 | 0.42 | 0.41 | 0.59 | 0.99 | 0.05 | 7.1 |
| | 3 | C | C | 0.10 | 0.38 | 0.27 | 0.25 | 0.51 | 0.49 | 1.00 | 0.06 | 4.1 |
| | 4 | A | D | 0.15 | 0.30 | 0.20 | 0.35 | 0.20 | 0.80 | 0.92 | 0.02 | 7.3 |
| | 5 | B | E | 0.18 | 0.23 | 0.23 | 0.36 | 0.59 | 0.41 | 1.01 | 0.36 | 3.2 |
| | 6 | C | F | 0.17 | 0.22 | 0.30 | 0.31 | 0.65 | 0.35 | 1.00 | ** | 10.4 |
| | 7 | A | G | 0.38 | 0.13 | 0.22 | 0.27 | 0.30 | 0.70 | 0.97 | 0.30 | 8.5 |
| | 8 | B | H | 0.29 | 0.23 | 0.07 | 0.41 | 0.33 | 0.67 | 0.94 | 0.06 | 1.0 |
| | 9 | C | I | 0.27 | 0.02 | 0.20 | 0.51 | 0.20 | 0.80 | 0.80 | ** | 20.0 |
| | 10 | A | J | 0.19 | 0.18 | 0.18 | 0.45 | 0.35 | 0.65 | 0.97 | 0.04 | 6.5 |
| Comparative Examples | 1 | A | A' | 0.14 | 0.29 | 0.02 | 0.55 | 0.10 | 0.90 | 0.68 | 0.22 | 5.4 |
| | 2 | B | B' | 0.01 | 0.02 | 0.19 | 0.78 | 0.52 | 0.48 | 0.66 | 0.03 | 6.7 |
| | 3 | C | C' | 0.16 | 0.66 | 0.01 | 0.17 | 0.38 | 0.62 | 0.79 | 0.08 | 4.6 |
| | 4 | A | D' | 0.08 | 0.01 | 0.09 | 0.82 | 0.48 | 0.52 | 0.66 | ** | 7.0 |
| | 5 | B | E' | 0.46 | 0.03 | 0.01 | 0.50 | 0.50 | 0.50 | 0.77 | ** | 2.8 |
| | 6 | C | F' | 0.01 | 0.33 | 0.59 | 0.07 | 0.39 | 0.61 | 0.79 | 0.05 | 10.5 |
| | 7 | A | G' | 0.67 | 0.19 | 0.01 | 0.13 | 0.45 | 0.55 | 0.79 | 0.46 | 7.6 |
| | 8 | B | H' | 0.20 | 0.01 | 0.76 | 0.03 | 0.66 | 0.34 | 0.66 | 0.03 | 1.2 |
| | 9 | C | I' | 0.11 | 0.01 | 0.70 | 0.18 | 0.59 | 0.41 | 0.76 | 0.04 | 19.6 |
| | 10 | A | J' | 0.09 | 0.09 | 0.06 | 0.76 | 0.37 | 0.63 | 0.73 | 0.11 | 6.2 |
| Conventional Examples | 1 | C | I'' | 1.00 | 0.00 | 0.00 | 0.00 | 0.62 | 0.38 | 0.33* | 0.04 | 4.9 |
| | 2 | A | J'' | 1.00 | 0.00 | 0.00 | 0.00 | 0.63 | 0.37 | 0.33* | 0.04 | 7.6 |

In Table 5, the configuration parameter $S_{config}$ is calculated from the expression $-R/2[b_1\ln(b_1)+b_2\ln(b_2)]$ because Conventional Examples 1-2 do not contain V, Zr, and Nb.

The symbol "**" indicates that the content was below the quantitative limit of the analyzer. In this case, a peak assign to chlorine in the characteristic X-ray spectrum was observed by single-element detection of chlorine only, which results confirm that chlorine was contained in trace amounts.

It was also confirmed that all of Examples, Comparative Examples, and Conventional Examples have crystal grains with a substantially NaCl-type face-centered cubic structure.

While each of Examples 1 to 10, Comparative Examples 1 to 10, and Conventional Examples 1 to 2 was screwed to the tip of a tool steel bite with a fixture, wet end face cutting tests were conducted on a hollow round bar of alloy steel SCM440 with two evenly spaced grooves to measure the flank wear width of the cutting edge.

This cutting test is a process in which flank wear readily progresses and the cutting edge is prone to chipping due to intermittent machining. Since this machining requires both wear resistance and chipping resistance, the test is suitable for the evaluation of hardness and toughness.

Cutting test

Workpiece material: JIS SCM440
Hollow round bar with two evenly spaced grooves (20 mm wide)
(Outer diameter: Φ180, inner diameter: Φ50)
Cutting speed: 250 m/min
Depth of cut: 1.5mm
Feed rate: 0.4 mm/rev
Number of cutting operations: 20 passes

Table 6 shows the results of the cutting test. For Comparative Examples 1 to 10 and Conventional Examples 1 to 2, the number of cutting passes to the end of the life is shown because the tool reached the life before the number of cutting operations reached 20 passes due to chipping or flank wear (criterion of life determination: flank wear width 0.4 mm) .

[Table 6]

| Type | | Width of flank wear (mm) | Type | | Number of cutting passes to reach lifetime | Type | | Number of cutting passes to reach lifetime |
|---|---|---|---|---|---|---|---|---|
| Examples | 1 | 0.16 | Comparative Examples | 1 | 15 | Conventional Examples | 1 | 8 |
| | 2 | 0.27 | | 2 | 14 | | | |
| | 3 | 0.17 | | 3 | 9 | | 2 | 9 |
| | 4 | 0.18 | | 4 | 5 | | | |
| | 5 | 0.21 | | 5 | 16 | | | |
| | 6 | 0.16 | | 6 | 8 | | | |
| | 7 | 0.25 | | 7 | 10 | | | |
| | 8 | 0.26 | | 8 | 18 | | | |
| | 9 | 0.23 | | 9 | 16 | | | |
| | 10 | 0.27 | | 10 | 10 | | | |

As the results shown in Table 6 indicate that Examples 1 through 10 all exhibited low wear, no chipping, improved hardness and toughness, and thus excellent cutting performance over a long period of time.
In contrast, Comparative Examples 1 through 10 and Conventional Examples 1 and 2 each exhibited a large amount of wear or chipping and reached the end of its service life within a short time.

<Examples of second embodiment>

1. Production of substrate

Substrates A to C made of WC-based cemented carbide with the same insert geometry of CNMG120408-MA manufactured by Mitsubishi Materials as in the first embodiment were produced.

2. Deposition

(TiVZrNbHfTa)(CN) layers were deposited on the surfaces of substrates A to C in a CVD system to yield Examples 11 to 15 shown in Table 9. The conditions for deposition were as shown in Table 7, and were generally as follows: Composition of reaction gas (content of gas component is in volume %):

$TiCl_4$: 0.02 to 0.10%
$VCl_4$: 0.02 to 0.10%
$ZrCl_4$: 0.10 to 0.50%
$NbCl_5$: 0.02 to 0.10%
*$HfCl_4$: 0.00 to 0.02%
*$TaCl_5$: 0.00 to 0.01%
$CH_3CN$: 0.10 to 0.50%
HCl: 0.10 to 0.50%
$N_2$: 0.0 to 12.0%
Ar: 10.0 to 50.0%
$H_2$: balance

*HfCl$_4$ and TaCl$_5$ are selected depending on the composition of the (TiVZrNbHfTa)(CN) layer.
Pressure of reaction atmosphere: 4.5 to 12.0 kPa
Temperature of reaction atmosphere: 800 to 950°C

For each of Examples 13 to 15, the bottom layer (s) and/or the top layer(s) shown in Table 8 were deposited under the conditions shown in Table 3.

For comparison, (TiVZrNbHfTa)(CN) layers were deposited on the surfaces of Substrates A to C according to the conditions for deposition shown in Table 7 to yield Comparative Examples 11 to 15 shown in Table 9. In the process of the comparative examples, the composition of the raw material gases was different from those of the examples. For Comparative Examples 13 to 15, the bottom layer(s) and/or the top layer(s) shown in Table 8 were deposited under the conditions shown in Table 3.

The average thickness of each layer, and the content of each element and the chlorine content in each layer were measured, and the NaCl-type face-centered cubic structure in each layer was identified for Examples 11 to 15 and Comparative Examples 11 to 15, by the methods described above.

The results are summarized in Table 9.

[Table 7]

| Type of deposition | Symbol of deposition | Deposition of (TiVZrNbHfTa)(CN) layer | | | | | | | | | | | | |
| | | Composition of reaction gas (volume %) | | | | | | | | | | | Reaction atmosphere | |
| | | | | | | | | | | | | | Pressure (kPa) | Temp. (°C) |
| | | TiCl$_4$ | VCl$_4$ | ZrCl$_4$ | NbCl$_5$ | HfCl$_4$ | TaCl$_5$ | CH$_3$CN | HCl | N$_2$ | Ar | H$_2$ | | |
| Step of Examples | K | 0.07 | 0.02 | 0.30 | 0.07 | 0.01 | 0.01 | 0.30 | 0.50 | 5.0 | 35.0 | Balance | 12.0 | 950 |
| | L | 0.05 | 0.05 | 0.30 | 0.05 | 0.02 | 0.00 | 0.30 | 0.50 | 5.0 | 50.0 | Balance | 12.0 | 800 |
| | M | 0.07 | 0.05 | 0.10 | 0.10 | 0.00 | 0.01 | 0.30 | 0.10 | 12.0 | 50.0 | Balance | 4.5 | 800 |
| | N | 0.10 | 0.10 | 0.50 | 0.05 | 0.01 | 0.00 | 0.10 | 0.30 | 0.0 | 25.0 | Balance | 4.5 | 950 |
| | O | 0.02 | 0.05 | 0.30 | 0.02 | 0.00 | 0.01 | 0.50 | 0.30 | 0.0 | 10.0 | Balance | 7.0 | 950 |
| Step of Comparative Examples | K' | 0.10 | 0.30 | 0.05 | 0.01 | 0.01 | 0.01 | 0.30 | 0.30 | 0.0 | 50.0 | Balance | 4.5 | 900 |
| | L' | 0.01 | 0.07 | 0.05 | 0.25 | 0.02 | 0.00 | 0.30 | 0.10 | 2.0 | 35.0 | Balance | 7.0 | 900 |
| | M' | 0.05 | 0.25 | 0.10 | 0.02 | 0.00 | 0.01 | 0.10 | 0.30 | 0.0 | 25.0 | Balance | 7.0 | 900 |
| | N' | 0.28 | 0.02 | 0.10 | 0.25 | 0.01 | 0.00 | 0.30 | 0.30 | 0.0 | 10.0 | Balance | 7.0 | 950 |
| | O' | 0.03 | 0.01 | 0.60 | 0.01 | 0.00 | 0.01 | 0.30 | 0.50 | 2.0 | 35.0 | Balance | 4.5 | 800 |

[Table 8]

| Type | | Substrate symbol | Coating layer (Lower number indicates average thickness (μm) of layer.) | | | |
| | | | Bottom layer(s) | | Top layer(s) | |
| | | | First sublayer | Second sublayer | First sublayer | Second sublayer |
| Examples & Comparative Examples | 13 | C | TiN (0.5) | – | – | – |
| | 14 | A | TiN (1.0) | TiCN (3.5) | TiCNO (0.4) | Al$_2$O$_3$ (4.5) |
| | 15 | B | TiN (0.3) | – | TiCNO (0.5) | Al$_2$O$_3$ (3.0) |

[Table 9]

| Type | | Substrate | Symbol of deposition | Content | | | | | | | | $S_{config}/R$ | Cl content (atomic %) | Average thickness ($\mu$m) |
|---|---|---|---|---|---|---|---|---|---|---|---|---|---|---|
| | | | | $a_1$ | $a_2$ | $a_3$ | $a_4$ | $a_5$ | $a_6$ | $b_1$ | $b_2$ | | | |
| Examples | 11 | A | K | 0.292 | 0.231 | 0.076 | 0.394 | 0.003 | 0.004 | 0.32 | 0.68 | 0.96 | 0.09 | 3.8 |
| | 12 | B | L | 0.197 | 0.242 | 0.135 | 0.421 | 0.005 | 0.000 | 0.44 | 0.56 | 1.01 | 0.06 | 6.7 |
| | 13 | C | M | 0.270 | 0.021 | 0.211 | 0.494 | 0.000 | 0.004 | 0.22 | 0.78 | 0.83 | ** | 12.4 |
| | 14 | A | N | 0.223 | 0.228 | 0.235 | 0.312 | 0.002 | 0.000 | 0.55 | 0.45 | 1.04 | 0.27 | 5.7 |
| | 15 | B | O | 0.103 | 0.384 | 0.261 | 0.244 | 0.000 | 0.008 | 0.49 | 0.51 | 1.01 | 0.08 | 4.5 |
| Comparative Examples | 11 | A | K' | 0.203 | 0.010 | 0.758 | 0.022 | 0.002 | 0.005 | 0.63 | 0.37 | 0.68 | 0.07 | 4.1 |
| | 12 | B | L' | 0.012 | 0.024 | 0.188 | 0.772 | 0.004 | 0.000 | 0.55 | 0.45 | 0.68 | 0.05 | 6.9 |
| | 13 | C | M' | 0.113 | 0.012 | 0.689 | 0.181 | 0.000 | 0.005 | 0.62 | 0.38 | 0.78 | 0.03 | 13.1 |
| | 14 | A | N' | 0.468 | 0.028 | 0.011 | 0.491 | 0.002 | 0.000 | 0.48 | 0.52 | 0.78 | ** | 5.1 |
| | 15 | B | O' | 0.160 | 0.671 | 0.019 | 0.141 | 0.000 | 0.009 | 0.33 | 0.67 | 0.79 | 0.09 | 4.8 |

The symbol "**" in Table 9 indicates that the content was below the quantitative limit of the analyzer. In this case, a peak assign to chlorine in the characteristic X-ray spectrum was observed by single-element detection of chlorine only, which results confirmed that chlorine was contained in trace amounts.

It was also confirmed that all of Examples, Comparative Examples, and Conventional Examples have crystal grains with a substantially NaCl-type face-centered cubic structure.

While each of Examples 11 to 15 and Comparative Examples 11 to 15 was screwed to the tip of a tool steel bite with a fixture, wet end face cutting tests were conducted on a hollow round bar of alloy steel SCM440 with two evenly spaced grooves to measure the flank wear width of the cutting edge.

This cutting test is a process in which flank wear readily progresses and the cutting edge is prone to chipping due to intermittent machining. Since this machining requires both wear resistance and chipping resistance, the test is suitable for the evaluation of hardness and toughness.

Cutting test

Workpiece material: JIS SCM440

Hollow round bar with two evenly spaced grooves (20 mm wide)
(Outer diameter: $\Phi$180, inner diameter: $\Phi$50)

Cutting speed: 250 m/min
Depth of cut: 1.5mm
Feed rate: 0.4 mm/rev
Number of cutting operations: 20 passes

Table 10 shows the results of the cutting test. For Comparative Examples 11 to 15, the number of cutting passes to the end of the life is shown because the tool reached the life before the number of cutting operations reached 20 passes due to chipping or flank wear (criterion of life determination: flank wear width 0.4 mm).

[Table 10]

| | Type | Width of flank wear (mm) | | Type | Number of cutting passes to reach lifetime |
|---|---|---|---|---|---|
| Examples | 11 | 0.22 | Comparative Examples | 11 | 18 |
| | 12 | 0.23 | | 12 | 17 |
| | 13 | 0.21 | | 13 | 17 |
| | 14 | 0.23 | | 14 | 16 |
| | 15 | 0.18 | | 15 | 8 |

As the results shown in Table 10 indicate that Examples 11 through 15 all exhibited low wear, no chipping, and improved both hardness and toughness, demonstrating excellent cutting performance over a long period of time.

In contrast, Comparative Examples 11 to 15 each showed a large amount of wear or chipping and reached the end of its service life in a short time.

The disclosed embodiments are in all respects illustrative only and are not restrictive. The scope of the invention is indicated by the claims, not the embodiments, and is intended to include all modifications within the gist and scope of the claims and equivalents.

Reference Numerals

1 Ti atom
2 anionic site (N atom)
3 anionic site (C atom)
4 cationic site (Ti, V, Zr, or Nb atom or Ti, V, Zr, Nb, Hf, or Ta atom (Hf and Ta are optional depending on composition))

**Claims**

1.   A surface coated cutting tool comprising:

a substrate and a coating layer on a surface of the substrate,
the coating layer comprising a complex carbonitride layer,
the complex carbonitride layer having an average thickness of 1.0 um or more and 20.0 um or less,
the complex carbonitride layer comprising NaCl-type face-centered cubic crystal grains each containing:

metal components Ti, V, Zr, and Nb in atomic fractions $a_1$, $a_2$, $a_3$, and $a_4$, respectively, where the total atomic fraction of the metal components in the layer is 1;
non-metallic components C and N in atomic fractions $b_1$ and $b_2$, respectively, where the total atomic fraction of the non-metallic components is 1; and
inevitable impurities, wherein

the atomic fractions $a_1$, $a_2$, $a_3$, $a_4$, $b_1$, and $b_2$ satisfy the following relations:

$$0.01 \leq a_1 \leq 0.60,$$

$$0.01 \leq a_2 \leq 0.60,$$

$$0.01 \leq a_3 \leq 0.60,$$

$$0.01 \leq a_4 \leq 0.60,$$

$$0.20 \leq b_1 \leq 0.80,$$

and $0.20 \leq b_2 \leq 0.80$,

the crystal grains each have a configuration parameter $S_{config}$ expressed by Expression 1 of 0.80R or more,

$$S_{config} = -\frac{R}{2}\left[\sum_{i=1}^{n} a_i ln(a_i) + \sum_{j=1}^{m} b_j ln(b_j)\right] \quad (1)$$

where n = 4 and m = 2, ln represents the natural logarithm, and R represents the gas constant.

2. The surface coated cutting tool set forth in Claim 1, wherein the complex carbonitride layer further contains at least one metallic component selected from the group consisting of Hf and Ta in atomic fractions of $a_5$ and $a_6$, respectively, wherein

the atomic fractions $a_5$ and $a_6$ satisfy the following relations:

$$a_5 < 0.01,$$

and

$$a_6 < 0.01,$$

respectively,

the crystal grains each have a configuration parameter $S_{config}$ expressed by Expression 1 of 0.80R or more,

where n = 6 and m = 2, ln represents the natural logarithm, and R represents the gas constant, with the proviso that if $a_i$ (i = 5 or 6) is zero (not contained), $a_i ln(a_i) = 0$.

3. The surface coated cutting tool set forth in Claim 1 or 2, wherein the complex carbonitride layer further contains 0.50 atomic percent or less of Cl.

[Fig.1]

[Fig. 2]

## INTERNATIONAL SEARCH REPORT

| International application No. |
|---|
| **PCT/JP2023/010052** |

### A. CLASSIFICATION OF SUBJECT MATTER

**B23B 27/14**(2006.01)i; **C23C 16/36**(2006.01)i
FI:  B23B27/14 A; C23C16/36

According to International Patent Classification (IPC) or to both national classification and IPC

### B. FIELDS SEARCHED

Minimum documentation searched (classification system followed by classification symbols)

B23B27/14; B23B51/00; B23C5/16; B23P15/28; C23C16/36; C23C14/06

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | US 2018/0223417 A1 (CITY UNIVERSITY OF HONG KONG) 09 August 2018 (2018-08-09)<br>paragraphs [0060]-[0065] | 1-3 |
| A | JP 2019-524623 A (GUARDIAN GLASS, LLC) 05 September 2019 (2019-09-05)<br>paragraphs [0012]-[0019] | 1-3 |
| A | JP 2021-101035 A (SANYO SPECIAL STEEL CO LTD) 08 July 2021 (2021-07-08)<br>paragraphs [0024]-[0026] | 1-3 |
| A | WO 2020/234484 A1 (OERLIKON SURFACE SOLUTIONS AG) 26 November 2020 (2020-11-26) | 1-3 |
| A | JP 2019-516007 A (SANDVIK INTELLECTUAL PROPERTY AB) 13 June 2019 (2019-06-13)<br>paragraphs [0054]-[0061] | 1-3 |
| P, A | JP 2022-168833 A (UNION TOOL KK) 08 November 2022 (2022-11-08) | 1-3 |

☐ Further documents are listed in the continuation of Box C.  ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **15 May 2023** | **23 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/010052**

| Patent document cited in search report | | | Publication date (day/month/year) | Patent family member(s) | | | Publication date (day/month/year) |
|---|---|---|---|---|---|---|---|
| US | 2018/0223417 | A1 | 09 August 2018 | (Family: none) | | | |
| JP | 2019-524623 | A | 05 September 2019 | US | 2018/0022928 | A1 | |
| | | | | paragraphs [0017]-[0023] | | | |
| | | | | WO | 2018/017304 | A2 | |
| | | | | KR | 10-2019-0030224 | A | |
| | | | | CN | 109715577 | A | |
| JP | 2021-101035 | A | 08 July 2021 | (Family: none) | | | |
| WO | 2020/234484 | A1 | 26 November 2020 | US | 2022/0220601 | A1 | |
| | | | | CN | 113966408 | A | |
| | | | | KR | 10-2022-0010026 | A | |
| | | | | CA | 3140095 | A | |
| JP | 2019-516007 | A | 13 June 2019 | US | 2021/0197288 | A1 | |
| | | | | paragraphs [0060]-[0068] | | | |
| | | | | WO | 2017/148885 | A1 | |
| | | | | CN | 108463301 | A | |
| | | | | KR | 10-2018-0116247 | A | |
| JP | 2022-168833 | A | 08 November 2022 | EP | 4083254 | A1 | |
| | | | | CN | 115247253 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022055518 A
- JP 4028891 B
- US 20160298233